# EUROPEAN PATENT APPLICATION

(11) **EP 2 450 491 A1**
(43) Date of publication of application: **09.05.2012**
(21) Application number: 10793570.2
(22) Date of filing: 22.06.2010
(51) Int. Cl.: E03C 1/00, E03D 1/00

(54) **AUTOMATIC SENSING SYSTEM AND METHOD**

(30) Priority: 30.06.2009 CN 200910054199
(71) Applicant: Shanghai Kohler Electronics, Ltd., Shanghai 201206 (CN)
(72) Inventor: CHEN, Zhongmin, Shanghai 201206 (CN); GAO, Pengcheng, Shanghai 201206 (CN); XIONG, Dehua, Shanghai 201206 (CN)
(74) Representative: Wightman, David Alexander
(86) International application number: PCT/CN2010/074216
(87) International publication number: WO 2011/000275

(57) **Abstract**

The present invention discloses an automatic sensing system and its detecting method used in the kitchen and washroom. Said automatic sensing system comprises an ambient light sensor for detecting the ambient light intensity around related equipments in the kitchen or washroom, a detecting sensor for detecting whether user enters the detected area, and a controller which controls the related equipments in the kitchen or washroom to proceed the corresponding operations based on detected result of the detecting sensor. Said controller starts the detecting sensor according to the value change of the ambient light intensity. The automatic sensing system saves more power and provides more accurate detection.

## Description

### Field of the Invention

Present invention relates to a kind of automatic sensing system and its working method, more particular to an automatic sensing system and its working method for controlling the automatic sensing faucet or other equipments in the kitchen or washroom.

### Background of the Invention

In prior art, sensors used for controlling the automatic sensing faucets and other equipments (such as urinals or closestools) in the kitchen or washroom are usually infrared sensors. A traditional infrared sensor comprises an infrared emitting device and infrared receiving device, wherein the infrared emitting device continuously emits infrared light to the detected area at regular time intervals, such as emitting once every 0.3 second, and said infrared receiving device receives the reflected infrared signals. By checking the intensity of the received infrared signals, it is judged whether the equipments in the kitchen or washroom are in use, thereby the performance of the related equipments are controlled, for example, the opening or closing of the automatic sensing faucet or the flushing of the urinals. To be specifically, the following is an example that infrared sensor is used for controlling the faucet. When the infrared sensor detects that user enters the detected area, the valve of the faucet is opened to discharge water; when the infrared sensor detects that the user has left the detected area, the valve of the faucet is closed to stop the water flow. The following is another example that infrared sensor is used for controlling the urinal. When the infrared sensor detects that the urinal is in use, the water discharging valve is opened for the first flush; when the infrared sensor detects that the user has left the detected area, the water discharging valve is opened for the last flush. As described above, it is an obvious technology that infrared sensor is used to control the faucet or the flushing equipments in the washroom in the field.

As the traditionally automatic sensing faucets use direct current power, hereby how to reduce the power consumed by the infrared sensor and extend the life of the battery become the focused subject of this technology field. In order to save power, the detecting method of the traditional infrared sensor has been improved. In normal use, the infrared sensor emits infrared light at comparatively lower frequency to detect. Once it is judged that a user is using the related equipments in the kitchen or washroom, the infrared sensor emits infrared light at higher frequency. However, on one hand this method is not very effective to save power; on the other hand it is inconvenient to the user. For instance, when the infrared sensor is used to control the faucet, the user has to wait for a long time before the water comes out from the faucet.

Although people keep improving the methods to realize low consumption of the infrared sensor, traditional infrared sensors have to continuously work no matter which emitting frequency of the infrared light is used. Thus, the power consumption of the infrared sensor is considerable. Usually, for an automatic sensing faucet which is used not so often (for example, the faucet is used 50 times a day), the power consumed to emit infrared light would be more than 30% of the total power consumption.

At the same time, in prior art the new types of sensors, such as microwave Doppler sensor, ultrasonic sensor, etc, are used to control the related equipments in the kitchen or washroom. Compared with the traditional infrared sensors, the new types of sensors have less restriction from the ambient. Whereas, those types of sensors consume more power, some of them even need alternating current to ensure its daily working.

No matter which kind of sensor and method are used, it always troubles us that the power consumption can not be reduced. Nowadays, to advocate power saving and ambient protection, people keep researching to invent an automatic sensing system which is more effective and consumes less power.

### Summary of the Invention

The object of present invention is to provide a kind of automatic sensing system and detecting method thereof which has lower power consumption and precise detecting.

The object of the present invention is realized by the following first technical solution. An automatic sensing system used in the kitchen or washroom comprises an ambient light sensor which detects the ambient light intensity around equipments in the kitchen or washroom, a detecting sensor for detecting whether user enters the detected area of said detecting sensor, and a controller which controls the related equipments in the kitchen or washroom to proceed the corresponding operations based on detected results of the detecting sensor. Based on the value changes of the ambient light intensity said controller starts the detecting sensor to make detection.

Further, the ambient light sensor is a photosensitive sensor.

Further, the photosensitive sensor is a passive photosensitive diode.

Further, said detecting sensor is an infrared sensor, which comprises an infrared emitting unit for emitting infrared light to the detected area and an infrared receiving unit for receiving the reflected infrared signals.

Further, said automatic sensing system also comprises an ambient light intensity detecting unit, the ambient light intensity detecting unit comprises a current-voltage transferring circuit connected to the ambient light sensor, and said current-voltage transferring circuit comprises an operating amplifier for outputting voltage.

Further, said current-voltage transferring circuit also comprises a capacitance which is in parallel to the operating amplifier to prevent the self-oscillation of the circuit.

The object of the present invention is realized by the following second technical solution. An automatic sensing system used in the kitchen or washroom comprises an ambient light sensor which detects the ambient light intensity around equipments in the kitchen or washroom, a detecting sensor for detecting whether user enters the detected area of said detecting sensor, and a controller which controls the related equipments in the kitchen or washroom to proceed the corresponding operations based on detected results of the detecting sensor. Based on the values of the ambient light intensity and the value changes of the ambient light intensity said controller starts the detecting sensor to make detection.

Further, the ambient light sensor is a photosensitive sensor.

Further, the photosensitive sensor is a passive photosensitive diode.

Further, said detecting sensor is an infrared sensor, which comprises an infrared emitting unit for emitting infrared light to the detected area, and an infrared receiving unit for receiving the reflected infrared signals.

Further, said automatic sensing system also comprises an ambient light intensity detecting unit, the ambient light intensity detecting unit comprises a current-voltage transferring circuit connected to the ambient light sensor, and said current-voltage transferring circuit comprises an operating amplifier for outputting voltage.

Further, said current-voltage transferring circuit also comprises a capacitance which is in parallel to the operating amplifier to prevent the self-oscillation of the circuit.

The object of the present invention is realized by the following third technical solution. An automatic detecting method for controlling related equipments in the kitchen or washroom comprises the following steps: sampling ambient light at regular time intervals and detecting the values of the ambient light intensity; starting the detecting sensor if the value change of the ambient light intensity is greater than the predetermined limited value to judge whether user enters the detected area of said detecting sensor or not.

Further, the sampling ambient light is performed by a photosensitive sensor.

Further, a passive photosensitive diode is used as the photosensitive sensor.

Further, said detecting sensor is an infrared sensor, which comprises an infrared emitting unit for emitting infrared light to the detected area and an infrared receiving unit for receiving the reflected infrared signals.

The object of the present invention is realized by the following fourth technical solutions. An automatic detecting method for controlling related equipments in the kitchen or washroom comprises the following steps: sampling ambient light at regular time intervals and detecting the values of the ambient light intensity; starting the detecting sensor if the values of the ambient light intensity lie in the range of the predetermined comparative threshold values and the value change of the ambient 5 light intensity is greater than the predetermined limited value to detect whether user enters the detected area of said detecting sensor or not.

Further, the sampling ambient light is performed by a photosensitive sensor.

Further, a passive photosensitive diode is used as the photosensitive sensor.

Further, said detecting sensor is an infrared sensor, which emits the infrared light at the normal working frequency to make judgment.

Further, said automatic detecting method also comprises dim light state judgment procedures: judging the ambient is under the dim light state if the value of the ambient light intensity is less than the value range of comparative threshold values, and then proceeding infrared judgment.

Further, under the dim light state, the frequency of the infrared judgment is lower than the normal working frequency.

Further, said automatic detecting method also comprises strong light state judgment procedures: judging the ambient is under the strong light state if the ambient light intensity is greater than the value range of comparative threshold values, and then proceeding infrared judgment.

Further, under the strong light state, the infrared judgment frequency is greater than the normal working frequency.

Further, under the strong light state, the infrared judgment frequency is equal to the normal working frequency.

Comparing with the prior art, by using passive or low power consumption ambient light sensor to pre-detect, and then starting the detecting sensor which consumes more power mainly according to the value change of the ambient light intensity to detect the usage state, further controlling the related equipments in the kitchen and washroom to perform the corresponding operations, the power consumption will be reduced, thus the automatic sensing system saves more power and detects more precisely.

### Brief Description of the Drawings

Fig. 1 is the structured flowchart of the automatic sensing system of the present invention.
Fig. 2 is the partial schematic figure of electric circuit of the automatic sensing system of the present invention.
Fig. 3 is the procedure sketch of one preferred embodiment of the automatic detecting method of the present invention.
Fig. 4 is the procedure sketch of another preferred embodiment of the automatic detecting method of the present invention.
Fig. 5 is the procedure sketch of another preferred embodiment of the automatic detecting method of the present invention.
Fig.6 is the procedure sketch of another preferred embodiment of the automatic detecting method of the present invention.
Fig. 7a is the schematic figure of the value of the sampled ambient light intensity without being disturbed by other lights.
Fig. 7b is the schematic figure of the value of the sampled ambient light intensity disturbed by other lights.
Fig. 8 is the procedure sketch of preventing the disturbance of the industrial frequency light in the automatic detecting method of the present invention.

### Detailed Description of the Invention

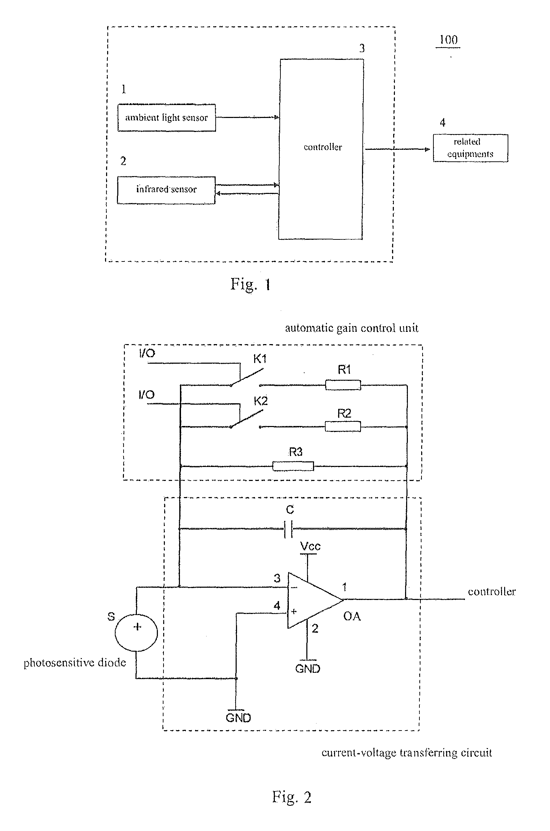

As described on Fig. 1, the automatic sensing system 100 of the present invention is used for controlling the automatic sensing faucet or other related equipments in the kitchen or washroom, such as urinals or toilets. In the embodiment shown on Fig. 1, the automatic sensing system of the present invention 100 comprises an ambient light sensor 1, an infrared sensor 2 and a controller 3, wherein said ambient light sensor 1 detects the value change of the ambient light intensity around the related equipment 4 in the kitchen or washroom and sends the detected results to controller 3. According to the value or value change of the ambient light intensity and other information, controller 3 decides whether the infrared sensor 2 is started or whether infrared sensor 2 changes to working state from the resting state. Once the infrared sensor 2 is started, it emits infrared light to detect if the targets (such as human body or hands) enter the detected area. Said infrared sensor 2 sends the detected results to the controller 3. The controller 3 processes said reflected infrared signals, and then decides further actions, for example, controlling the faucet valve to discharge water, closing the faucet valve to stop water, or controlling other related equipments in the kitchen or washroom.

Said ambient light sensor 1, which is a photosensitive sensor used for detecting the ambient light, could be a photosensitive diode, a photosensitive transistor or a photosensitive resistance etc. In one of the preferred embodiments, the photosensitive diode is used as ambient light sensor 1. The photosensitive diode is a kind of semiconductor, which could convert light energy into electric energy, and usually uses the silicon photoelectric cell. The photosensitive diode is a passive sensing element and usually called the passive photosensitive diode, which doesn't consume energy. Therefore, compared with photosensitive transistor or photosensitive resistance, the photosensitive diode is used as the ambient light sensor that doesn't consume any energy. However, if the condition is good, such as the capacity of the battery is enough, the ambient light sensor 1 could be photosensitive transistor or photosensitive resistance etc.

Said infrared sensor 2 comprises an infrared emitting unit and an infrared receiving unit. Usually LED is used as infrared emitting unit, which emits infrared light to the detected area. Said infrared receiving unit receives the infrared signals reflected from the detected area and sends the reflected signals to the controller 3 to process.

Said controller 3 is connected with the ambient light sensor 1, infrared sensor 2 and the operating mechanism of the related equipment 4 in the kitchen or washroom to process information and control the related operating mechanism to perform the related operations.

The basic operating procedures of the automatic sensing system 100 of the present invention are as follows.

Ambient light sensor 1 detects the value and value change of ambient light intensity at regular time intervals, for example, it detects once every 0.3 seconds.

When no user is in the detected ambient, the ambient light intensity detected by said ambient light sensor 1 doesn't change, or it changes slowly. Hence, the infrared sensor 2 does not work or emits infrared light to its detected area at intervals of longer time, for example, it emits once every 2 seconds. In present text, it is called resting state while infrared sensor 2 emits infrared light at intervals of longer time. The infrared sensor 2 is still working in the resting state.

When the user approaches the related equipment 4 in the kitchen or washroom, said ambient light sensor 1 detects that the ambient light intensity around the related equipment 4 changes suddenly. And then, ambient light sensor 1 sends the detected signals of the sudden value change of the ambient light intensity to controller 3.

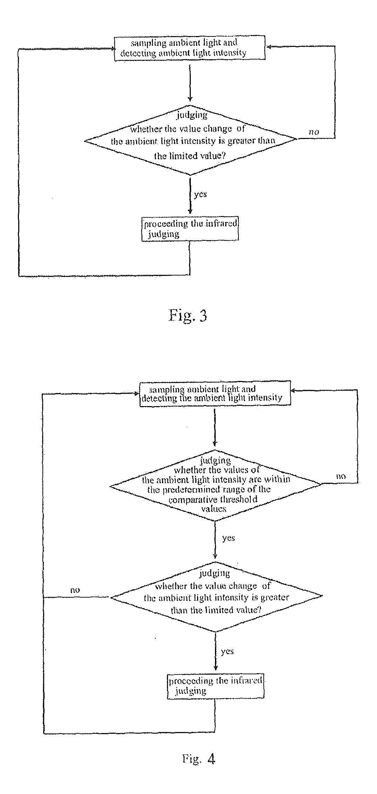

Controller 3 processes the received signals of the sudden value change of the ambient light intensity and judges whether the value change of the ambient light intensity could meet the request of the predetermined limited value, such as judging whether the value change of the ambient light intensity is greater than the predetermined limited value or not. Once the value change of the ambient light intensity meets the request of the predetermined limited value, infrared sensor 2 is started to emit infrared light to its detected area at normal working frequency. In the following embodiments of the present invention, the normal working frequency of infrared sensor 2 is that infrared light is emitted once every 0.3 seconds. The infrared sensor 2 can be also changed to the normal working state from the resting state, and emit infrared light to the detected area at normal working frequency. In another embodiment of the present invention, besides judging whether the value change of the ambient light intensity meets the request of the predetermined limited value, the value of the ambient light intensity is also judged to see if it meets the request of the predetermined limited value, viz. after judging the intensity value is within the predetermined range of the comparative threshold values, it is judged whether the value change of the ambient light intensity is greater than predetermined limited value. Please see the descriptions in the embodiment shown on Fig. 4 of automatic detecting method of the present invention, hereon we don't describe it.

The infrared emitting unit of said infrared sensor 2 emits infrared light to identify and judge the exact position of the user. The infrared receiving unit of the infrared sensor 2 sends the reflected signals to controller 3 and further the controller 3' processes the reflected infrared signals to control the related equipment 4 in the kitchen or washroom to perform, such as ordering the faucet to discharge water or opening the solenoid valve of the urinals to flush.

As mentioned above, when no one uses the related equipment, the infrared sensor 2 is in non-working state or resting state. Only when the value change of ambient light intensity detected by ambient light sensor 1 and other values meet the request of the predetermined limited value, the infrared sensor 2 is started to work or changes to the working state from the resting state. Said ambient light sensor 1 consumes no energy or little energy. Thus, compared with prior art, the present automatic sensing system 100 could reduce the system consumption efficiently. Further, the way that takes the value change of ambient light intensity as the standard to start the infrared sensor makes the judgment more precise and reliable.

The automatic sensing system 100 of the present invention comprises an ambient light intensity detecting unit. In the present invention, the voltage values corresponding to the ambient light intensity are taken as the values of the ambient light intensity. Said ambient light intensity detecting unit comprises current-voltage transferring circuit (shown on Fig. 2). Said photosensitive diode converts the ambient light intensity into electric current signals to output, the stronger the ambient light becomes, the greater the electric current becomes. Since the photosensitive diode is used as ambient light sensor, an ambient light intensity detecting unit is needed. The ambient light intensity detecting unit converts the current signals sent by the photosensitive diode into voltage signals, and the voltage signals are sent to the controller. The controller processes the voltage signals and calculates its values, and then the values of ambient light intensity are figured out. Said current-voltage transferring circuit comprises an operating amplifier OA used for making the current-voltage transferring and a capacitance C which is parallel to the operating amplifier OA to prevent self-oscillation of the circuit. In one of the preferred embodiments, ST Company's TS_941 is used as the operating amplifier OA. Its working voltage could be as low as 2.5V and its working current could be as low as 1.2 microampere.

The automatic sensing system 100 of the present invention also has automatic gain control unit. By the automatic gain control unit, the detected ambient light signals are set within the range where said detected ambient light signals could be more easily identified and the detecting could be more precise. Said automatic gain control unit comprises automatic gain control circuit (shown on Fig. 2). Said automatic gain control circuit comprises a first analog switch K1, a second analog switch K2, a first resistance R1 which is in series with the first analog switch K1, a second resistance R2 which is in series with the second analog switch K2 and third resistance R3 which is parallel to R1, R2. Said automatic gain control unit changes the feedback resistance by means of controlling K1 and K2 to realize the automatic gain control (AGC) on the ambient light.

Through the above-mentioned automatic gain control unit, the automatic gain control could be divided into four grades. At the first grade, analog switches K1and K2 are switched on, and R1 R2 and R3 are parallel to each other. Second grade, first analog switch K1 is switched on; second switch K2 is switched off and R1 and R3 form an electric path. Third grade, K1 is switched off; K2 is switched on and R2, R3 forms the electric path. Fourth grade, K1 and K2 are switched off and R3 forms an electric path.

In one of the preferred embodiments of the present invention, the resistance R1 is 470K, R2 is 2M and R3 is 20M. While the analog switches K1, K2 are switched on, the feedback resistance is about 380K; while K1 is switched on and K2 is switched off, the feedback resistance is about 470K; while K1 is switched off and K2 is switched on, the feedback resistance is about 1.8M; while K1 K2 are switched off, the feedback resistance is about 20M.

Of course, according to the actual usages, the automatic gain control of the automatic gain control unit in the present invention could be two grades of control or other multiple grades of control. The automatic gain control circuit is changed correspondingly.

The working procedures of the above-mentioned automatic gain control unit are described as follows.

The range (P2, P1) of comparative threshold values are set in advance, wherein the first comparative threshold value is P1 and the second comparative threshold value is P2.

When the voltage values corresponding to the ambient light intensity are greater than the first comparative threshold value P1 the feedback resistance is decreased and the gain is reduced. Specially, when the voltage values corresponding to the ambient light intensity are greater than the first comparative threshold value P1 and the gain has been the minimum, the ambient is judged as in the strong light state, that is the state under the direct irradiation of light.

When the voltage values corresponding to the ambient light intensity are less than the second comparative threshold value P2, the feedback resistance is increased and the gain is enhanced. Specially, when the voltage values corresponding to the ambient light intensity are less than the second comparative threshold value P2 and the gain has been the maximum, the ambient is judged as in the dim light state, and viz it is night or dark state.

While the ambient is in the above-mentioned strong light or dim light state, the infrared sensor 2 is started directly for making infrared judgment. In dim light state or dark state (such as at night), the equipments are used not so often, so the infrared emitting frequency is less than the normal working frequency, such as emitting once every 0.5 seconds or 0.8 seconds. In dim light state, it is better that the time period for emitting infrared light is between 0.5 seconds to 1 second. In the strong light state, the infrared emitting frequency is greater than or equal to the normal working frequency, such as emitting once every 0.3 seconds as the normal working frequency or emitting once every 0.2 seconds which is greater than the normal working frequency.

In one of the preferred embodiments of the present invention, the first comparative threshold value P1 is 80% of the highest voltage value of the circuit and the second comparative threshold value P2 is 20% of the highest voltage value of the circuit. By choosing the above-mentioned resistance and comparative threshold values, controlling backlash could be effectively eliminated and the gain would not be changed too often. In addition, the dim light state mode and strong light state mode make the automatic sensing system 100 of the present invention more reliable and perfect.

By means of the above-mentioned circuit, automatic sensing system 100 of the present invention could detect within the extent between 0.5LUX and 1000LUX, which could satisfy the practical needs in the kitchen or washroom.

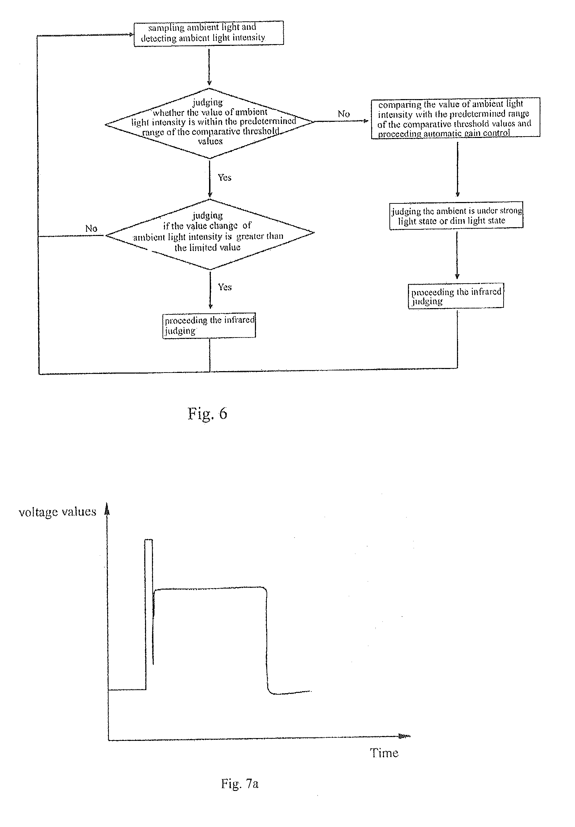

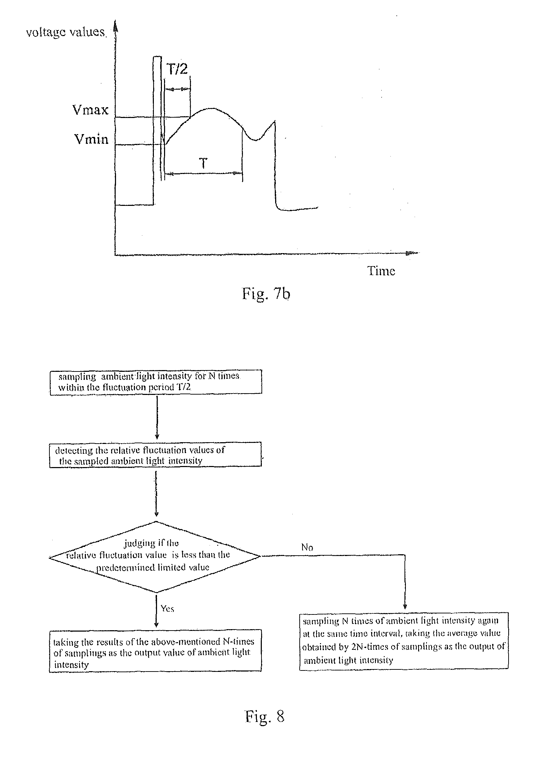

Since the automatic sensing system 100 of the present invention is used in the kitchen or washroom, it is easily disturbed by industrial frequency lights, such as fluorescent lamp and so on. As shown on Fig. 7a and 7b, while automatic sensing system of the present invention is not disturbed by other lights, the voltage values corresponding to sampled ambient light intensity are smooth. While it is disturbed by other lights, the voltage values corresponding to sampled ambient light intensity fluctuates obviously. As a result, while it is disturbed by other light, the voltage values corresponding to sampled ambient light intensity can not show the real situation, which would lead to wrong judgment. Therefore, the automatic sensing system of the present invention also comprises a unit for preventing the disturbance of the industrial frequency lights. Said unit for preventing the disturbance of the industrial frequency lights could effectively prevent the disturbance of industrial frequency lights when the ambient light is sampled, so the ambient light intensity detected by ambient light sensor I is more precise, and the performance of the whole system is enhanced.

As shown on Fig. 8, the working procedure of unit for preventing the disturbance of the industrial frequency lights is described as the following.

Usually, the disturbing period T of the disturbance of the industrial frequency light is half-wave of the industrial frequency (for example: 50Hz/60Hz).

First, within the period T/2, the ambient light intensity is sampled for N times at regular time intervals. In one of the preferred embodiments of the present invention, N is 5.

Second, the relative fluctuation value ΔV of the sampled ambient light intensity is calculated. In one of the preferred embodiments, the formula ΔV=(Vmax-Vmin) /((Vmax+Vmin)/2) is used to calculate. Said Vmax and Vmin are the highest and the lowest voltage values corresponding to the ambient light intensity within the T/2 period.

Third, it is judged whether the relative fluctuation value ΔV is less than the predetermined limited value W. If the relative Fluctuation value ΔV is less than the predetermined limited value W, it is judged that the automatic sensing system is not disturbed by the industrial frequency light, and the average value of the results of the above-mentioned N times of samplings is taken as the output of the ambient light intensity. If the relative fluctuation value ΔV is not less than the predetermined limited value W, it proves that the automatic sensing system is disturbed by the industrial frequency light. The ambient light will be sampled for N times again at the same time interval and the average value of the results of 2N times of samplings is taken as the output of the ambient light intensity.

In one of the preferred embodiments of the present invention, said value W is 3%.

Owing to the unit for preventing the disturbance of the industrial frequency lights adopts the different means to calculate the ambient light intensity for the two situations that the automatic sensing system is or isn't disturbed by the industrial frequency lights, it could reduce the energy consumption and go with the trend of energy saving and environmental protection.

As shown on Fig. 3, in one of the preferred embodiments of the automatic detecting method of the present invention, automatic detecting method of the present invention comprises the following steps.

The first step, the ambient light is sampled and the value of the ambient light intensity is detected. Said ambient light sensor 1 samples the ambient light at regular time intervals and sends the voltage values corresponding to ambient light to controller 3 to be processed by means of current-voltage transferring circuit, and then the value of the ambient light intensity is figured out. The time interval for detecting the ambient light intensity is determined as T1, and T1 is 0.3 seconds.

The second step, it is judged whether the value change of the ambient light intensity is greater than the predetermined limited value. If the value change of the ambient light intensity is greater than predetermined limited value, the procedure enters the third step and starts the infrared sensor 2; if the value change of the ambient light intensity is not greater than the predetermined limited value, the procedure returns to the first step to sample the ambient light and detect ambient light intensity again.

The predetermined limited value change of the ambient light intensity is K. If the value change of the ambient light intensity is greater than predetermined limited value change K two times continuously, it is judged that there is sudden changed signal, and the procedure enters the third step; otherwise, it is judged there is no sudden changed signal and the procedure returns to the first step to sample the ambient light and detect the values of ambient light intensity over again. In one of the preferred embodiments of the present invention, said predetermined limited intensity value change K is 5%.

During this step, the above-mentioned value change of the ambient light intensity is the value change between two continuously detected values of the ambient light intensity. However, under some situations, such as the user moves slowly, if the judgment is decided only based on the value change of the ambient light intensity, the judgment might fail as the intensity value change is not greater than the predetermined limited value change. Therefore, in other embodiments of the present invention, the judgment of the value change of the ambient light intensity may also base on the value changes which are sampled within a period of time interval, such as judging the value changes sampled within one time interval, two times of intervals or several sampling periods.

The third step is to proceed the infrared judgments and detect the target. The infrared sensor 2 is started, and this step also comprises that the infrared sensor 2 is changed to the working state from the resting state, wherein the time period for the infrared judgment is 2 seconds and the working frequency is that infrared light is emitted once every 0.3 seconds.

If it is detected that no user enters the detected area in regulated judgment time period, the infrared judgment stops, and the procedure returns to the first step to starts the ambient light detecting over again. If it is detected that the user enters the detected area, the related equipments are controlled to work, such as opening or closing the valve of the faucet. After the relative operation is completed, the infrared judgment stops, and the procedure returns to the first step to starts the ambient light intensity detecting over again.

In order to enhance the precision of the ambient light detecting, in one of the preferred embodiments of the present invention, the procedure for judging the value of the ambient light intensity is added. Reference to Fig. 4, automatic detecting method of the present invention comprises the following steps.

The first step, the ambient light is sampled and the value of the ambient light intensity is detected. Said ambient light sensor 1 samples the ambient light at regular time intervals and sends the voltage values corresponding to ambient light to controller 3 to be processed by means of the current-voltage transferring circuit, and then the value of the ambient light intensity is detected. The time interval for detecting the ambient light intensity is T1, and T1 is 0.3 seconds.

The second step, it is judged whether the value of the ambient light intensity is within the predetermined range of the comparative threshold values. If the ambient light intensity goes beyond the range of the predetermined comparative threshold values, the procedure returns to the first step. If the ambient light intensity is within the predetermined range of threshold values, the procedure enters the third step.

the predetermined range of comparative threshold values is (P2, P1), wherein P1 is the first comparative threshold value and P2 is the second comparative threshold value. In one of the preferred embodiment of the present invention, said first comparative threshold value P1 is 80% of the highest voltage value of the circuit and the second comparative threshold value P2 is 20% of the highest voltage value of the circuit.

The third step, it is judged whether the value change of the ambient light intensity is greater than the predetermined limited value change. If the value change of the ambient light intensity is greater than the predetermined limited value change, the procedure enters the fourth step and the infrared sensor is started to make infrared judgment; if the value change of the ambient light intensity is not greater than the predetermined limited value change, the procedure returns to the first step to sample the ambient light and detect ambient light intensity over again.

The predetermined limited value change of the ambient light intensity is K. If two continued value changes of the ambient light intensity are greater than the predetermined limited value change K, it is judged that there is sudden change signal, and then the procedure enters the fourth step; otherwise it is judged that there is no sudden change signal, and then the procedure returns to the first step to sample the ambient light and detect ambient light intensity over again. In one of the preferred embodiments of the present invention, said predetermined limited intensity value change K is 5%.

During this step, the above-mentioned value change of the ambient light intensity is the value change between two continuously detected values of the ambient light intensity. However, under some situations, for example, when the user moves slowly, if the judgment is decided only based on two continued value changes of the ambient light intensity, the judgment might fail as the value changes are not greater than the predetermined limited value change. Therefore, in other embodiments of the present invention, the judgment of the value change of the ambient light intensity may also be based on the value change which is sampled within a period of time interval, such as judging the value changes sampled within one time of interval, two times of intervals or several sampling periods.

The fourth step is to proceed the infrared judgments and detect the target. The infrared sensor 2 is started, and this step also comprises that the infrared sensor 2 changes to the working state from resting state, wherein the time period for the infrared judgment is 2 seconds and the working frequency is once every 0.3 seconds.

While making the infrared judgment, if it is detected that no user enters the detected area in regulated judgment time period, the infrared judgment stops, and the procedure returns to the first step to start ambient light detecting over again. If it is detected that the user enters the detected area, the related equipment is controlled to work, such as opening or closing the valve of the faucet. After the relative operation is completed, the infrared judgment stops, and the procedure returns to the first step to start ambient light intensity detecting over again.

In this embodiment, the procedure of judging whether the value of the ambient light intensity is within the range of comparative threshold values is added, and it is further judged whether the value change of the ambient light intensity is greater than the predetermined limited value. Those make the judgment more precise.

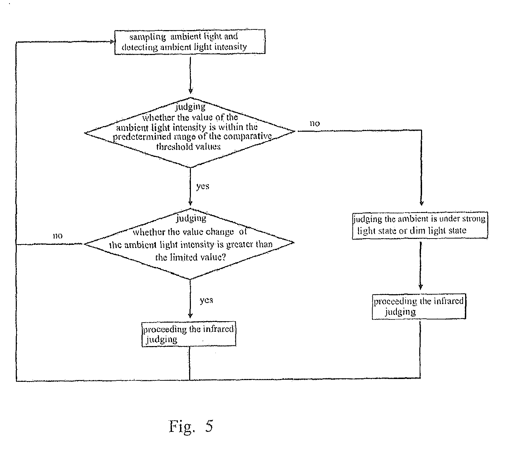

As shown on Fig. 5, in another preferred embodiment of automatic detecting method of the present invention, in order to ensure the automatic sensing system works effectively under dim light condition (at night) or strong light condition, the automatic sensing method of the present invention adds the dim light state mode judgment and strong light state mode judgment based on the second preferred embodiment. The procedures are described as follows.

The first step, the ambient light is sampled and the value of the ambient light intensity is detected. Said ambient light sensor 1 samples the ambient light at regular time intervals and sends the voltage value corresponding to ambient light to controller 3 to be processed by means of current-voltage transferring device, and then the value of the ambient light intensity is detected. The predetermined time interval for detecting the ambient light intensity is T1, and T1 is 0.3 seconds.

The second step, it is judged whether the value of the ambient light intensity is within the predetermined range of comparative threshold values. If the ambient light intensity goes beyond the range of the predetermined comparative threshold values, the procedure enters the third step. If the ambient light intensity is within the predetermined range of threshold values, the procedure enters the forth step.

The predetermined range of comparative threshold values is (P2, P1), wherein P1 is the first comparative threshold value and P2 is the second comparative threshold value. In one of the preferred embodiment of the present invention, said first comparative threshold value P1 is 80% of the highest voltage value of the circuit and the second comparative threshold value P2 is 20% of the highest voltage value of the circuit.

The third step, comparing the value of the ambient light intensity with the predetermined first and second comparative threshold values P1 and P2, it is judged whether the ambient is under the dim light state or strong light state.

When the ambient light intensity is greater than the first comparative threshold value P1, the ambient is judged as under the strong light state, and then the infrared sensor 2 is started for making infrared judgments. The judgment frequency in the strong light state mode is greater than or equal to the normal working frequency. In one of the preferred embodiments, in strong light state mode, the time period for the infrared judgment is 60 seconds and the judgment frequency is once every 0.2 seconds. In another preferred embodiment, in strong light state mode, the time period for the infrared judgment is 60 seconds and the judgment frequency is once every 0.3 seconds.

When the ambient light intensity is less than the comparative threshold value P2, the ambient is judged as under the dim light state, and then the infrared sensor 2 is started for making infrared judgments. The judgment frequency in the dim light state mode is less than the normal working frequency. In the dim light state mode, the time period for the infrared judgment is 60 seconds and the judgment frequency is once every 0.5 seconds. However, the judgment frequency could be once every 0.8 seconds. Usually, it is better that the range of the judgment frequency is once within 0.5 seconds to 1 second.

The fourth step, it is judged whether the value change of the ambient light intensity is greater than predetermined limited value change. If the value change of the ambient light intensity is greater than the predetermined limited value change, the procedure enters the fifth step and the infrared sensor is started; if value change of the ambient light intensity is not greater than the predetermined limited value change, the procedure returns to the first step to sample the ambient light and detect ambient light intensity over again.

The predetermined limited value change of the ambient light intensity is K. If two continued value changes of the ambient light intensity are greater than the predetermined limited value change K, it is judged that there is sudden changed signal, and then the procedure enters the fifth step. If the two continued value changes of the ambient light intensity are not greater than the predetermined limited value change K, it is judged there is no sudden changed signal and then the procedure returns to the first step to sample the ambient light and detect ambient light intensity over again. In one of the preferred embodiments, said predetermined limited value change K is 5%.

During this step, the above-mentioned value change of the ambient light intensity is the value change between two continuously detected values of the ambient light intensity. However, under some conditions, for example, the user moves very slowly. If the judgment is decided only based on the continuous value changes of the ambient light intensity, it would lead to wrong judgment as the value change of the ambient light intensity may be less than the predetermined limited value change. Therefore, in other embodiments of the present invention, the judgment of the value change of the ambient light intensity is based on the judgment of value change of the ambient light intensity at certain of time intervals, such as judging the value change of the ambient light intensity sampled at one time of interval, two times of intervals or several sampling periods.

The fifth step is to proceed the infrared judgment and detect the target. The infrared sensor 2 is started, and this step also comprises that the infrared sensor 2 changes to the working state from resting state, wherein the time period for making the infrared judgment is 2 seconds and the working frequency is once every 0.3 seconds.

While making the infrared judgment, if it is detected that no user enters the detected area in regulated judgment time period, the infrared judgment stops, and the procedure returns to the first step to make ambient light detecting over again. If it is detected that the user enters the detected area, the related equipments are controlled to work, such as opening or closing the valve of the faucets. After the relative operation is completed, the infrared judgment stops, and the procedure returns to the first step to make ambient light intensity detecting over again.

Further, in one of the preferred embodiments of automatic detecting method of the present invention, the present invention also comprises automatic gain adjustment. Referenced to Fig. 6, the present invention automatic detecting method comprises the following steps.

The first step, the ambient light is sampled and the value of the ambient light intensity is detected. Said ambient light sensor 1 samples the ambient light at regular time intervals, and sends the voltage value corresponding to ambient light intensity to controller 3 to be processed by means of current-voltage transferring circuit, and then the value of the ambient light intensity is detected. The predetermined time interval for detecting the ambient light is T1, and T1 is 0.3 seconds.

The second step, it is judged whether the ambient light intensity is within the predetermined range of comparative threshold values. If the ambient light intensity is within the range of the predetermined comparative threshold values, the procedure enters the third step. If the ambient light intensity is within the predetermined range of comparative threshold values, the procedure enters the fourth step.

The predetermined range of comparative threshold values is (P1, P2), wherein P1 is the first comparative threshold value and P2 is the second comparative threshold value. In one of the preferred embodiment of the present invention, said first comparative threshold value P1 is 80% of the highest voltage value of the circuit and the second comparative threshold value P2 is 20% of the highest voltage value of the circuit.

The third step, comparing the ambient light intensity with the first and second comparative values P1 and P2, automatic gain adjustment is performed.

When the ambient light intensity is greater than the first comparative threshold value P1, further it is judged whether the gain control is on the lowest grade. If the gain control is not on the lowest grade, the gain control is lowered by one grade. If the gain control is on the lowest grade, the ambient is judged as under the strong light state, and then the infrared sensor 2 is started for making infrared judgments. The judgment frequency in the strong light state mode is greater than or equal to the normal working frequency. In one of the preferred embodiments, under strong light mode, the time period for making the infrared judgment is 60 seconds, and the judgment frequency is once every 0.2 seconds. In another preferred embodiments, in strong light state mode, the time period for the infrared judgment is 60 seconds, the judgment frequency is once every 0.3 seconds.

Specially, in one of the preferred embodiments of the present invention, after the gain control is lowered by one grade, the procedure directly returns to the first step to sample the ambient light and detect ambient light intensity over again. However, in another preferred embodiment of the present invention, after the gain control is lowered by one grade, the infrared sensor may be started for making the infrared judgments, wherein the time period for the infrared judgment is 2 seconds and the judgment frequency is once every 0.3 seconds.

When the ambient light intensity is less than the second comparative threshold value P2, further it is judged that if the gain control is on the highest grade. If the gain control is not on the highest grade, the gain control is increased by one grade. If the gain control is on the highest grade, the ambient is judged as under the dim light state, and then the infrared sensor is started for making infrared judgments. In the dim light state mode, the judgment frequency is less than the normal working frequency, the time period for making the infrared judgment is 60 seconds and the judgment frequency is once every 0.5 seconds. However, the judgment frequency could be once every 0.8 seconds. Usually, it is better that the range of the judgment frequency is to judge once within 0.5 seconds to 1 second.

Specially, in one of the preferred embodiments of the present invention, after the gain control is increased by one grade, the procedure directly returns to the first step to sample the ambient light and detect ambient light intensity over again. However, in another preferred embodiment of the present invention, after the gain control is increased by one grade, the infrared sensor may be started for making infrared judgment, wherein the time period for making the infrared judgment is 2 seconds, and the judgment frequency is once every 0.3 seconds.

The judgment frequency in the dim light state mode is lower than the normal working frequency. In dim light mode, it is highly possible that it is at night or in dark state. In this situation, the equipments are not used so often, so the judgment frequency is lowered to realize low consumption. The judgment frequency in strong light state mode is higher than the normal working frequency. Increasing the judgment frequency in strong light state mode makes the judgment more precise.

The fourth step, it is judged whether the value change of the ambient light intensity is greater than the predetermined limited value change. If the value change of the ambient light intensity is greater than the predetermined limited value change, the procedure enters the fifth step, and the infrared sensor 2 is started for making infrared judgments. If the value change of the ambient light intensity is not greater than the predetermined limited value change, the procedure returns to the first step to sample the ambient light and detect ambient light intensity over again.

The predetermined limited value change of the ambient light intensity is K. If the two continued value changes of the ambient light intensity are greater than K, it is judged that there is sudden changed signal, and then the procedure enters the third step; If the two continued value changes of the ambient light intensity are less than K, it is judged there is no sudden changed signal and then the procedure returns to the first step to sample the ambient light and detect ambient light intensity over again. In one of the preferred embodiments of the present invention, said predetermined limited value change K is 5%.

During this step, the above-mentioned value change of the ambient light intensity is the value change between two continuously detected values of the ambient light intensity. However, under some situations, the user moves slowly. If the judgment is decided only based on the continuous value changes of the ambient light intensity, the judgment might fail as the intensity value change is not greater than the predetermined limited value. Therefore, in other embodiments of the present invention, the judgment of the value change of the ambient light intensity may also be based on the value changes within a period of time interval, such as judging the value changes sampled within one time of interval, two times of intervals or several sampling periods.

The fifth step is to start infrared judgment and detect the target. The infrared sensor 2 is started, and this procedure also comprises that the infrared sensor 2 changes to the working state from resting state, wherein the time period for making the infrared judgment is 2 seconds and the working frequency is once every 0.3 seconds.

While making the infrared judgment, if it is detected that no user enters the detected area in regulated judgment time period, the infrared judgment stops, and the procedure returns to the first step to make ambient light detecting over again. If it is detected that the user enters the detected area, the related equipment is controlled to work, such as opening or closing the valve of the faucet. After the relative operation is completed, the infrared judgment stops, and the procedure returns to the first step to make ambient light intensity detecting over again.

As shown on Fig. 7a and 7b, when the judgment is not disturbed by other lights, the voltage value corresponding to the sampled ambient light is smooth. When the judgment is disturbed by other lights, the voltage value corresponding to the sampled ambient light is fluctuating obviously. As a result, when the judgment is disturbed by other light, the voltage value corresponding to the sampled ambient light can not show the real situation, which would lead to wrong judgment. In order to get reliable judgment, the automatic detecting method of the present invention also comprises the procedure of preventing the disturbing of the industrial frequency lights when the ambient light is sampled and the ambient light intensity is detected. Since the automatic sensing system of the present invention is used in the kitchen or washroom, the judgment is easily disturbed by industrial frequency lights, such as fluorescent lamp and so on. The unit for preventing the disturbance of the industrial frequency lights could prevent the disturbance of industrial frequency lights, so the ambient light sensor could detect the ambient light precisely, and the performance of the whole system is enhanced.

As shown on Fig. 8, the followings are the specific procedures.

The first step: within the time period of T/2, the ambient light intensity is sampled for N times at the even time interval.

Usually, the disturbing period T of the disturbance of the industrial frequency is half wave of the industrial frequency (for example: 50Hz/60Hz). Thus, within the time period of T/2, the ambient light intensity is sampled for N times at the even time interval. In one of the preferred embodiments of the present invention, N is 5.

The second step, the relative fluctuation value ΔV of the sampled ambient light intensity is calculated. In one of the preferred embodiments, the formula ΔV= (Vmax-Vmin) /((Vmax+Vmin)/2) is used to calculate fluctuation value ΔV. Said Vmax and Vmin are the highest and the smallest value of the voltage of the ambient light intensity within the T/2 time period.

The third step, it is judged if the relative fluctuation value ΔV is less than the predetermined limited value W. If the relative fluctuation value ΔV is less than the predetermined limited value W, it is judged that there is no disturbance of the industrial frequency lights and the procedure enters the fourth step. If the relative fluctuation value ΔV is not less than the predetermined limited value W, it is judged that there is disturbance of the industrial frequency lights and the procedure enters the fifth step. In one of the preferred embodiments of the present invention, said value W is 3%.

The fourth step, the average value of the above-mentioned N times of sampling is taken as the output of the ambient light intensity.

The fifth step, the ambient light intensity is sampled for N times at the same time interval, and the average value obtained by the above-mentioned 2N times of sampling is taken as the output of the ambient light intensity.

The followings are the illustrative description in combination with faucet that adopts the automatic sensing system and detecting method of the present invention.

The ambient light sensor 1 and infrared sensor 2 of the automatic sensing system 100 of the present invention are installed on the faucet body respectively, and controller 3 is connected with ambient light sensor 1 and infrared sensor 2 to control the water discharging valve of the faucet. The ambient light sensor 1 is set beside the outlet of the faucet to detect the value changes of the ambient light intensity under the faucet. Infrared sensor 2 is set at the base or the outlet of the faucet to detect whether the target (user's hands) enters or leaves the detected area.

When a user approaches the faucet to use it, the ambient light under the outlet of the faucet will be changed. When the ambient light sensor 1 detects that the value change of the ambient light intensity is greater than the predetermined limited value, the infrared sensor 2 is started or changes to the working state from resting state. As the user's hands enter the detected area of infrared sensor 2, the controller 3 opens the solenoid valve of the faucet to discharge water. The controller 3 closes the solenoid valve of the faucet to stop the water after the infrared sensor 2 detects that user's hands have left the detected area. Afterwards, the infrared sensor 2 is closed or changes to resting state from working sate. When the ambient light sensor 1 detects that the ambient is under the dim light or strong light state, infrared sensor emits infrared light on the preset procedure.

The automatic sensing system and detecting method of the present invention could also be used for urinals, toilets or other equipments in the kitchen or washroom.

In the embodiments of the present invention, the ambient of the ambient light sensor 1 could be the same as the detected area of the infrared sensor 2, or be different area depending on practical usage.

In the embodiments of the present invention, starting the infrared sensor 2 means to change the infrared sensor 2 from non-worlcing state to working state or from resting state to working state. It should be specially noted that the infrared sensor 2 is still working under resting state; however, the infrared emitting frequency is low (such as emitting once every 2 seconds). In some situations, the ambient light sensor 1 could not normally work because it is blocked by foreign matters, or the change of the ambient light is tiny while the target enters the detected ambient. At the moment, if the infrared sensor 2 which is in resting state detects that the target enters the detected area, the infrared sensor 2 enters normal working state from the resting state and emits infrared light at normal working frequency (such as emitting once every 0.3 seconds), as well it sends the detected result to controller 3 to proceed relative operations. After the above-mentioned situation appears twice or more times continuously, the infrared sensor 2 enters the normal working state until it is judged that the user has left the detected area and the ambient light sensor I works normally, viz. the infrared sensor 2 will work with the normal working procedure as before, and will be started based on the value change of the ambient light intensity detected by the ambient light sensor 1. Thus, the present invention also comprises the method for preventing the system malfunction, and the followings are the procedures.

When it is detected by the ambient light sensor 1 that the ambient light doesn't change or the value change of the ambient light intensity is less than the predetermined limited value, and the infrared sensor 2 that is under the resting state detects and finds the target, the infrared sensor 2 emits infrared light at normal working frequency.

When the above-mentioned situation appears for N times continuously (N is greater than 1), infrared sensor 2 keeps emitting infrared light at normal working frequency. In one of the preferred embodiments of the present invention, N is equal to 2. The predetermined limited value change of the ambient light intensity is K. In one of the preferred embodiments of the present invention, the predetermined limited value change K is 5%.

When it is judged that the ambient light sensor 1 detects and finds the ambient light changes and the value change of the ambient light intensity is greater than the predetermined limited value change, it is known that the ambient light sensor 1 is working well. Therefore, the infrared sensor 2 does not emit infrared light at normal working frequency. It follows the normal procedure and starts depending on the value change of the ambient light intensity detected by the ambient light sensor 1.

Moreover, the infrared sensor 2 in above embodiments could be replaced by microwave sensor, ultrasonic sensors or other sensors which could detect the targets enter the detected area. For example, the microwave sensor is used to replace the infrared sensor. When the ambient light sensor detects that the ambient light intensity changes in the ambient and the value change is greater than the predetermined limited value change, the microwave sensor is started or changes from resting state to working sate to detect whether the target enters the detected area. If the microwave sensor does not detect and find that any target enters the detected area, it is closed or enters resting state after a definite time period (such as 2 seconds). If the microwave sensor detects and finds that the target enters or leaves the detected area, it proceeds the corresponding operations by the controller, such as controlling the solenoid valve to discharge water or close the valve to stop water. Afterwards, the microwave sensor is closed or enters resting state. The above-mentioned infrared sensor, microwave sensor, ultrasonic sensors or other sensors which could detect the target that enters the detecting area, all could be called "detecting sensor". It should be specified that "starting" of the detecting sensor described in the embodiments of the present invention means to change the state of the detecting sensor from the non-working state to the working state or from the resting state to the working state. The photosensitive sensors used for detecting the ambient light, such as photosensitive diode, photosensitive transistor or photosensitive resistance etc., all could be called "ambient light sensor".

Compared with the way that makes judgment only based on the values of the ambient light intensity, it is more reliable to judge based on the value change of the ambient light intensity in the present invention. It is easy to cause misjudgment if the judgment is made only according to whether the ambient light intensity is greater than a definite value. For example, in the strong light state, the ambient light intensity detected by the ambient light sensor is always greater than the definite value; in dim light state, the ambient light intensity detected by the ambient light sensor is always less than the definite value. Obviously, the ambient light sensor can not work normally in the above-mentioned situations. In the present invention, the judgments are based on the value change of the ambient light intensity, which is more intelligent and reliable and could eliminate the above-mentioned defects. Specifically, when the value change of the ambient light intensity is greater than the predetermined limited value change, the detecting sensor is started. Further, in the present invention, the judgment is made based on both the value of the ambient light intensity and value change of the ambient light intensity, which made the present invention more reliable. Particularly, when the ambient light intensity is within the range of the comparative threshold values and the value change of the ambient light intensity is greater than the predetermined limited value change, the detecting sensor is started to detect. In some special situations, when the value change of the ambient light intensity is greater than the predetermined limited value change or the ambient light intensity is within the range of the comparative threshold values at the same time, it is judged that the related equipments in the kitchen or washroom are in use.

Although the present invention has been described and illustrated in detail, they do not limit the extent of the present invention. The modification or change made by a skilled person in this field is also within the extent of the present invention.

## Claims

1. An automatic sensing system used in the kitchen or washroom, **characterized in that** said automatic sensing system comprises an ambient light sensor for detecting the ambient light intensity around the equipments in the kitchen or washroom, a detecting sensor for detecting whether user enters the detected area of said detecting sensor, and a controller which controls the related equipments in the kitchen or washroom to proceed the corresponding operations based on detected results of the detecting sensor, and based on the value changes of the ambient light intensity said controller starts said detecting sensor to make detection.

2. An automatic sensing system according to claim 1, **characterized in that** said ambient light sensor is a photosensitive sensor.

3. An automatic sensing system according to claim 2, **characterized in that** the photosensitive sensor is a passive photosensitive diode.

4. An automatic sensing system according to claim 1, **characterized in that** said detecting sensor is an infrared sensor, which comprises an infrared emitting unit which emits infrared light to the detected area and an infrared receiving unit which receives the reflected infrared signals.

5. An automatic sensing system according to claim 1, **characterized in that** said automatic sensing system also comprises an ambient light intensity detecting unit, said ambient light intensity detecting unit further comprises a current-voltage transferring circuit connected with said ambient light sensor, and said current-voltage transferring circuit comprises an operating amplifier for outputting electrical voltage.

6. An automatic sensing system according to in claim 5, **characterized in that** said current-voltage transferring circuit also comprises a capacitance which is in parallel to said operating amplifier to prevent self-oscillation of the circuit.

7. An automatic sensing system used in the kitchen or washroom, **characterized in that**: said automatic sensing system comprises an ambient light sensor used for detecting the ambient light intensity around the equipments in the kitchen or washroom, a detecting sensor for detecting whether user enters the detected area of said detecting sensor, and a controller which controls the related equipments in the kitchen or washroom to proceed the corresponding operations based on detected results of the detecting sensor, and based on the values of the ambient light intensity and value changes of ambient light intensity said controller starts the detecting sensor to make detection.

8. An automatic sensing system according to claim 7, **characterized in that** said ambient light sensor is a photosensitive sensor.

9. An automatic sensing system according to claim 8, **characterized in that** said photosensitive sensor is a passive photosensitive diode.

10. An automatic sensing system according to claim 7, **characterized in that** said detecting sensor is an infrared sensor, which comprises an infrared emitting unit for emitting infrared light to the detected area and an infrared receiving unit for receiving the reflected infrared signals.

11. An automatic sensing system according to claim 7, **characterized in that** said automatic sensing system also comprises an ambient light intensity detecting unit, said ambient light intensity detecting unit further comprises a current-voltage transferring circuit connected with the ambient light sensor, and said current-voltage transferring circuit comprises an operating amplifier for outputting voltages.

12. An automatic sensing system according to claim 11, **characterized in that** said current-voltage transferring circuit also comprises a capacitance which is in parallel to the operating amplifier to prevent the self-oscillation of the circuit.

13. A kind of automatic detecting method to control the related equipments in the kitchen or washroom, **characterized in that** it comprises the following steps:
sampling ambient light at regular time intervals, and detecting the values of the ambient light intensity;
starting the detecting sensor if the value change of the ambient light intensity is greater than the predetermined limited value to judge whether user enters the detected area of said detecting sensor.

14. An automatic detecting method according to claim 13, **characterized in that** said sampling ambient light is performed by a photosensitive sensor.

15. An automatic detecting method according to claim 14, **characterized in that** a passive photosensitive diode is used as said photosensitive sensor.

16. An automatic detecting method according to claim 13, **characterized in that** said detecting sensor is an infrared sensor, which comprises an infrared emitting unit for emitting infrared light to the detected area and an infrared receiving unit for receiving the reflected infrared signals.

17. An automatic detecting method for controlling related equipments in the kitchen or washroom, **characterized in that** it comprises the following steps:
sampling ambient light at regular time intervals, and detecting the values of the ambient light intensity;
starting the detecting sensor if the values of the ambient light intensity lie in the predetermined range of comparative threshold values and the value change of the ambient light intensity is greater than the predetermined limited value change to judge whether user enters the detected area of said detecting sensor.

18. An automatic detecting method according to claim 17, **characterized in that** said sampling ambient light is performed by a photosensitive sensor.

19. An automatic detecting method according to claim 18, **characterized in that** a passive photosensitive diode is used as said photosensitive sensor.

20. An automatic detecting method according to claim 17, **characterized in that** said detecting sensor is an infrared sensor which emits infrared light at the normal working frequency to make judgment.

21. An automatic detecting method according to claim 20, **characterized in that** said automatic detecting method also comprises dim light state judgment procedures:
judging the ambient is under the dim light state if the value of the ambient light intensity is less than the value range of comparative threshold values, and then proceeding infrared judgment.

22. An automatic detecting method according to claim 21, **characterized in that** under the dim light state, the frequency of the infrared judgment is lower than the normal working frequency.

23. An automatic detecting method according to claim 20, **characterized in that** said automatic detecting method also comprises strong light state judgment procedures:
judging the ambient is under the strong light state if the value of the ambient light intensity is greater than the value range of comparative threshold values, and then proceeding infrared judgment.

24. An automatic detecting method according to claim 23, **characterized in that** under the strong light state, the frequency of the infrared judgment is greater than the normal working frequency.

25. An automatic detecting method according to claim 23, **characterized in that** under the strong light state, the frequency of the infrared judgment is equal to the normal working frequency.
